# EUROPEAN PATENT APPLICATION

(11) **EP 4 195 014 A1**
(43) Date of publication of application: **14.06.2023**
(21) Application number: 21306753.1
(22) Date of filing: 13.12.2021
(51) Int. Cl.: G06F 3/04815, G06F 3/04845, G06F 30/00, G06T 19/00

(54) **MULTI-RENDER USER INTERFACE**

(71) Applicant: Dassault Systèmes, 78140 Vélizy-Villacoublay (FR)
(72) Inventor: DELFINO, Christophe, 06906 Biot (FR)
(74) Representative: Atout PI Laplace

(57) **Abstract**

The disclosure notably relates to a computer-implemented method for rendering at least two visualization modes of a 3D model. The method comprises rendering (S10) the 3D model in a main view according to a first visualization mode. The method further comprises splitting (S20) the main view in at least two split views. Each split view corresponding to one visualization mode of a plurality of visualization modes. The method further comprises, for each split view, determining (S30) a rendering area of the 3D model associated to the current split view. The method further comprises rendering (S40) the 3D model in each split view according to its corresponding visualization mode and determined rendering area. This constitutes an improved method for rendering various visualization modes of a 3D model simultaneously.

## Description

### TECHNICAL FIELD

The present disclosure relates to the field of computer programs and systems, and more specifically to a method, system and program for rendering visualization modes of a 3D model.

### BACKGROUND

User interfaces are nowadays used in a wide range of applications. Indeed, they allow users to interact with 3D objects, according to different angles of views. User interfaces are adaptable to a wide range of contexts. For example, the 3D modeling and/or the rendering may be performed locally, by the computer the user interacts with, or remotely in a server, the user interacting with images that are sent by the server. In the latter case, the user interface and corresponding tool may be provided by SaaS (Software as a Service).

One of the applications allowed by interface is CAD (Computer-Aided Design), which consists in using a computer to design products in 3D. A number of systems and programs are offered on the market for the design, the engineering and the manufacturing of objects. CAE is an acronym for Computer-Aided Engineering, e.g. it relates to software solutions for simulating the physical behavior of a future product. CAM is an acronym for Computer-Aided Manufacturing, e.g. it relates to software solutions for defining manufacturing processes and operations. In such computer-aided design systems, the graphical user interface plays an important role as regards the efficiency of the technique. These techniques may be embedded within Product Lifecycle Management (PLM) systems. PLM refers to a business strategy that helps companies to share product data, apply common processes, and leverage corporate knowledge for the development of products from conception to the end of their life, across the concept of extended enterprise.

The PLM solutions provided by Dassault Systèmes (under the trademarks CATIA, ENOVIA and DELMIA) provide an Engineering Hub, which organizes product engineering knowledge, a Manufacturing Hub, which manages manufacturing engineering knowledge, and an Enterprise Hub which enables enterprise integrations and connections into both the Engineering and Manufacturing Hubs. All together the system delivers an open object model linking products, processes, resources to enable dynamic, knowledge-based product creation and decision support that drives optimized product definition, manufacturing preparation, production and service.

In CAD solutions and authoring programs, the user needs to be able to see various renders, each render corresponding to a specific visualization mode of a 3D model. When selecting a visualization mode of their 3D model or even of their entire 3D scene, it helps the user to render the various visualization modes available. Changing visualization mode of a 3D model or of a 3D scene may be used to produce marketing deliverables like realistic rendering images/videos or 3D interactive experiences based on the 3D model or the entire 3D scene. Changing visualization mode of a 3D model or of a 3D scene may also be useful during the design of a 3D model. A visualization mode comprises a set of parameters configuring the rendering of a 3D model. These parameters are used as input to render the 3D model. These parameters are functional data intended to computer resources such as the central processing unit (CPU) and/or graphic processing unit (GPU) resources, therefore the user cannot directly infer the render of a visualization mode for a 3D model from these parameters.

As an example, CAD solutions provide different user interfaces to render various visualization modes of a 3D model. A general definition of the term rendering is the process of generating a photorealistic or non-photorealistic image from a 3D model by means of a computer program. The resulting image is referred to as the render. A render is also commonly called a rendering. Rendering is a highly demanding process in term of computer resources. It is handled by the graphics pipeline in a CPU and/or in a rendering device such as a GPU. Real-time rendering is therefore challenging, especially for a CAD 3D model having a high number of topological entities.

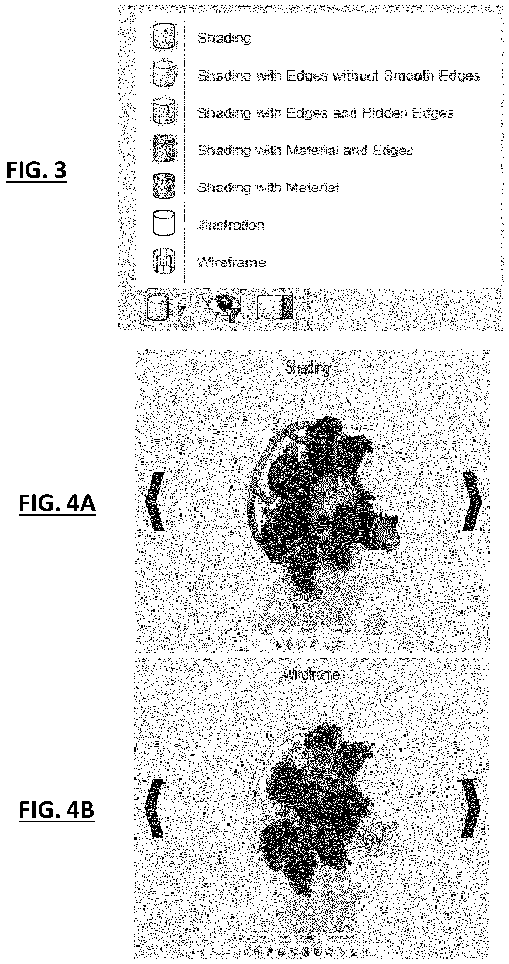

A first group of known methods for rendering various visualization modes of a 3D model allows only one rendering at a time of an entire 3D model and/or 3D scene. As an example, a list of commands is provided, each command launching a rendering of one visualization mode of the 3D model. Therefore, the user opens a list of commands from a toolbar and can choose one of the rendering in this list to apply to the 3D model. FIG. 3 shows an example of a list of commands wherein each command is materialized by an icon and a text. Another example, shown in FIG. 4A and FIG. 4B, provides the ability to the user to switch between renderings by swiping the screen with his finger or by interacting with a button.

This first group of methods suffers several drawbacks. First, before selecting a visualization mode, the user does not see what the render looks like. Therefore, he has to see the renders corresponding to various, and sometimes all, visualization modes before knowing which one is the best for their need. For example, if the user is not satisfied with the result, he has to open the list again, to select another render and to restart the same process. Furthermore, there is one command for each visualization mode available. As a result, there are many commands and the user loses a lot of time searching for the right command to use. Consequently, these drawbacks increase the mouse miles and the click number. A second problem is that only one render of a visualization mode is displayed at a time: the user has to memorize one or more renders to compare it to the current render displayed.

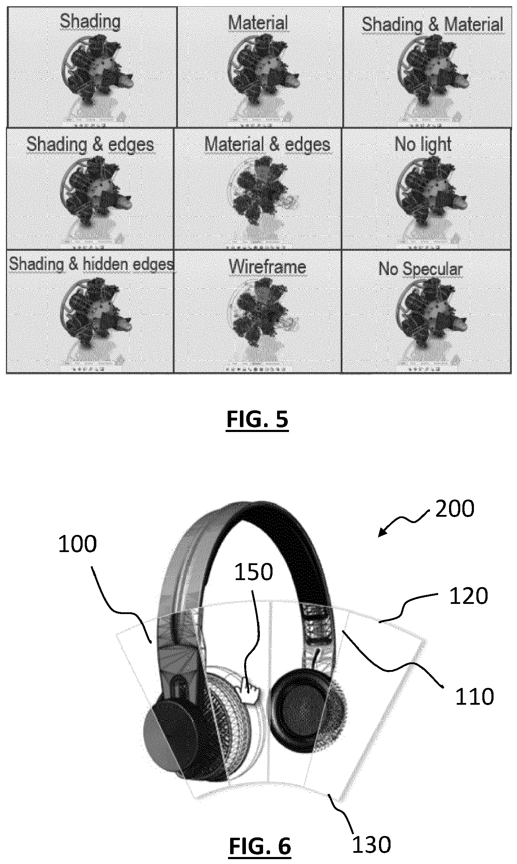

A second group of known methods for rendering various visualization modes of a 3D model allows a visualization of the various renderings of an entire 3D model and/or 3D scene. As shown in FIG. 5, the screen is divided into various viewers and a render corresponding to one visualization mode is displayed in each viewer.

This second group of methods has also many inconvenient. First, it is costly in term of CPU and/or GPU resources. Depending on the specifications of the material used to generate the renders, generating several renders in real-time is not always possible, therefore the viewers may appear with a delay. Furthermore, if the user wants to change the current point of view of the various viewers, there may be a delay following the user interactions as the renders have to be computed for each modification of the point of view. Second, dividing the screen into various viewers induces that each render is small, therefore it is difficult to visualize correctly the details of the 3D model in each render.

Within this context, there is still a need for an improved method for rendering various visualization modes of a 3D model. Preferably, the method allows the visualization of various renders simultaneously while reducing the cost to generate these renderings.

### SUMMARY

It is therefore provided a computer-implemented method for rendering at least two visualization modes of a 3D model. The method comprises rendering S10 the 3D model in a main view according to a first visualization mode. The method further comprises splitting S20 the main view in at least two split views. Each split view corresponding to one visualization mode of a plurality of visualization modes. The method further comprises, for each split view, determining S30 a rendering area of the 3D model associated to the current split view. The method further comprises rendering S40 the 3D model in each split view according to its corresponding visualization mode and determined rendering area.

Such a method constitutes an improved method for rendering various visualization modes of a 3D model simultaneously.

The method may comprise one or more of the following:
- the method further comprising:
   - receiving S50 a selection of one of the plurality of visualization modes;
   - removing S60 the at least two split views; and
   - rendering S70 the 3D model according to the selected visualization mode in the main view.
- the receiving S50 comprises a user interaction with one split view corresponding to the selected visualization mode.
   - each split view comprises a 2D interface, the 2D interface comprising one icon and/or a text.
   - the split views are circle sectors having a shared circle center with a same central angle and radius length.
   - the split views are circle sectors having a shared circle center with a same central angle and radius length and wherein the 2D interface is displayed between the shared center of the split views and the split views.
   - the method further comprising a step S80 of selecting one of the split views and enlarging it by increasing its central angle and/or increasing its radius length.
   - the method further comprising a step S90 of rotating one of the split views about the shared circle center and/or enlarging one of the split views upon receiving an input from a user, the input comprising an interaction with one of the split views.
   - the shared center of the split views is located inside the main view and the method further comprising a step S100 is of movable moving the shared center by an input from a user.
   - the shared center of the split views is located outside the main viewer.
   - each split view is separated to its neighbor by a radius line or by an angular space.

It is further provided a computer program comprising instructions for performing the method.

It is further provided a computer readable storage medium having recorded thereon the computer program.

It is further provided a computer adapted to perform the method.

It is further provided a system comprising a processor coupled to a memory, the memory having recorded thereon the computer program.

### BRIEF DESCRIPTION OF THE DRAWINGS

Non-limiting examples will now be described in reference to the accompanying drawings, where:
- FIG. 1 shows a flowchart of an example of the method;
- FIG. 2 shows a flowchart of an example of further steps compatible with the method;
- FIG. 3, 4A, 4B and 5 show an example of prior arts for rendering various visualization modes of a 3D model;
- FIG. 6 is a screenshot depicting a first example of the invention;
- FIG. 7A and 7B are screenshots depicting a second example of the invention;
- FIG. 8A and 8B are screenshots depicting an example of user interaction of the second example of the invention;
- FIG. 9 is a screenshot depicting a third example of the invention;
- FIG. 10 is a screenshot depicting an example of user interaction of the third example of the invention;
- FIG. 11 to 18 are simplified representations of various examples of the invention;
- FIG. 19 is a screenshot depicting a fourth example of the invention;
- FIG. 20 is a screenshot depicting a fifth example of the invention;
- FIG. 21 is a screenshot depicting the first example of the invention used on a touch sensitive display; and
- FIG. 22 shows an example of a system for performing the invention.

### DETAILED DESCRIPTION

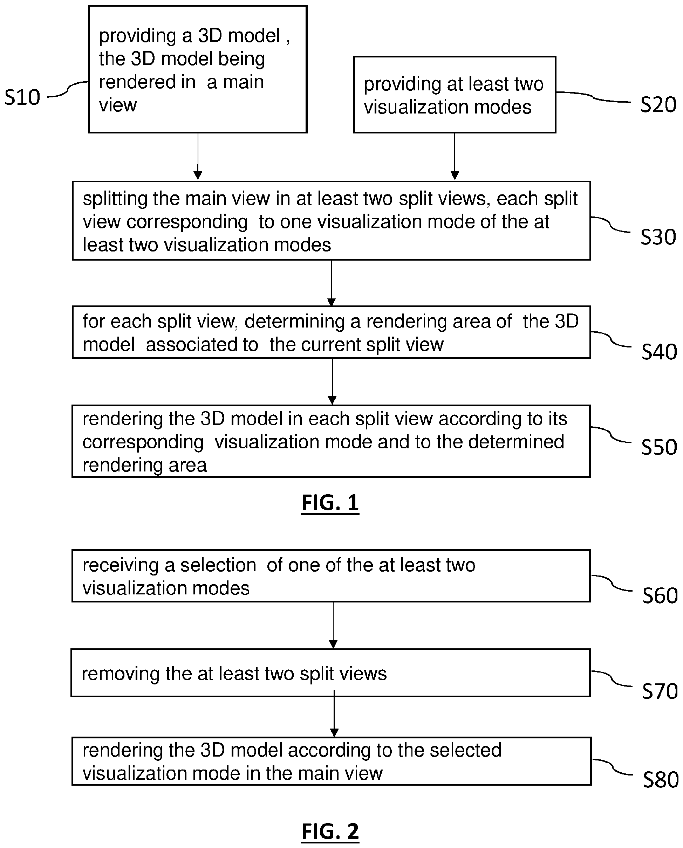

With reference to the flowchart of FIG. 1, it is proposed a computer-implemented method for rendering at least two visualization modes of a 3D model.

A 3D model is rendered S10 in a main view 200 according to a first visualization mode. Then the main view 200 is split S20 in at least two split views 100. Each split view 100 corresponds to one visualization mode of a plurality of visualization modes. Then, for each split view, a rendering area of the 3D model associated to the current split view 100 is determined S30. Finally, the 3D model is rendered S40 in each split view 100 according to its corresponding visualization mode and determined rendering area.

This constitutes an improved method for rendering at least two visualization modes of a 3D model. Indeed, the method renders various visualization modes of a 3D model simultaneously while limiting the impact on the performances by rendering only a portion of the 3D model in each split view. Therefore there are no part of the 3D model which is being rendered simultaneously in two different split views 100. Said otherwise, the cost of rendering various visualization modes of a 3D model is limited as there is no part of the 3D model which is rendered more than once at a time.

The method also displays various renders of the 3D model next to each other. Therefore the method eases the comparison between various renders of a 3D model as the user can see the various renders next to each other without further needed user interaction. Being able to see a render is especially important to compare various visualization modes, which comprise parameters configuring the rendering of a 3D model. Indeed, the parameters of a visualization mode are functional data intended to computer resources such as the CPU and/or GPU resources, therefore the user cannot compare various visualization modes based on these parameters. In other words, by allowing the user to compare various renders, the method credibly reduces the number of user interactions needed to compare visualization modes. Furthermore, the method allows a quick update of the renders during a modification of the point of view and/or a modification of the position and/or orientation of the 3D model. As an example, the determining S30 and the rendering S40 may be performed for each modification in order to update the renders of the 3D model in each split view.

Visualization is any technique for creating images, diagrams and/or animations to communicate a message. A visualization mode is based on a specific technique and/or based on a specific set of parameters for generating images, diagrams and/or animations. In other words, two visualization modes may be based on two different techniques or on one single technique but with two different sets of parameters. Visualization modes are used for various applications such as scientific visualization, data visualization, educational visualization, knowledge visualization, product visualization, visual communication and visual analytics. The visualization may also be interactive.

As an example, scientific visualization, knowledge visualization, product visualization and visual communication are often used in CAD. Flow visualization, constraints visualization and/or temperature visualization are some visualization modes used for scientific visualization. Shading with edges visualization, shading with material visualization, wireframe visualization and/or illustration visualization are some visualization modes used for product visualization. An annotated visualization is an example of a knowledge visualization. By "rendering a visualization mode", it is meant generating a render based on the technique and the set of parameters contained in the visualization mode by using the computer resources such as the CPU/GPU resources.

A 3D model is any 3D data representation of a 3D object. As an example, a 3D model may be a 3D mesh or a 3D point cloud. It may also comprise textures and/or 2D/3D notes. CAD applications allow creating accurate 3D models. A 3D model is considered accurate when the 3D model reproduces faithfully a corresponding real 3D object. One criteria is to minimize the differences between the envelopes of the 3D model and the real object. Therefore, 3D models created with CAD applications traditionally contain many small topological elements for the bumpy rough parts of the 3D objects. As an example, in CAD applications, a 3D mesh may contain more than 10⁶ or even 10⁹ faces. Rendering these 3D models is resource consuming. It is therefore challenging to render in real time 3D models having a great number of topological entities.

First, the method renders S10 the 3D model in a main view 200 according to a first visualization mode. A view occupies an area on the screen and displays the 3D model on a two-dimensional (2D) surface. A view, also called a 3D view, is a display of a 3D model from a point of view on a 2D surface, the point of view comprising a 3D position and a 3D orientation. The 3D model may be comprised in a 3D scene. The 3D model may be a 3D model of a physical object. A 3D scene may comprise more than one 3D model. The described method is compatible with a 3D scene comprising more than one 3D model. Advantageously, the method would be performed for rendering at least two visualization modes of a 3D scene.

The main view 200 is the view used in step S10 to render the 3D model. For example, the main view 200 is pre-existent to our method. As an example, it is the view wherein the design of the 3D model is performed. The main view 200 may also render the 3D model based on a preferred visualization mode. The preferred visualization mode may be chosen by the user or automatically selected by the application. For example, the selected visualization mode may be a default visualization mode in order to ensure that the rendering is real-time with the current resources of the computer. Subsequently other views may be created by the application and/or the user.

A visualization mode is defined by a technique of rendering and a set of parameters. As an example, a plurality of lightning visualization modes could comprise a parameter for setting the number of lights, the orientation and the position of each light, the type of each light (punctual, infinite or directional), the intensity and the color of each light. Each lightning visualization mode would have a different combination of values for these parameters. Other visualization modes, for example those based on shaders, comprise parameters which are functional data. These parameters set the internal functioning of the computer, for example the graphics card. Each visualization mode is different from the other visualization modes. The number of visualization modes to render may be comprised between 2 to more than 100, and more preferably between 2 to 8. When the number of visualization modes is too large, for example more than 10, it is preferable to group the visualization modes by categories and to render only the visualization modes of a selected category. The grouping of the visualization may be provided or performed between steps S20 and S20 by the user with any standard user interface such as a multiple selection listbox. Then the user may perform a selection of the category of visualization modes to render. For example, the user can launch a command to choose a category of visualization modes grouped under "lightning" for the current 3D model or the 3D scene and will get an immersive selector with viewers showing various lightning visualization modes. Next, the user can launch a rendering command and the viewers will be updated with rendering visualization options. The selection of the visualization modes to render may also be performed without a grouping.

The method splits S20 the main view 200 in at least two split views 100, each split view 100 corresponding to one visualization mode of a plurality of visualization modes. Said otherwise, each split view 100 displays the render of one visualization mode. Additional views are created during the splitting S20 by dividing the main view 200. After step S20, the main view 200 is partially or entirely hidden by the split views 100. The main view 200 may no longer be visible at least partially on the screen after step S20. As an example, the main view 200 may be replaced by the split view 100 after step S20. In another example, the main view 200 may still exist after step S20 but be hidden partially to the user by the split views 100. The number of split views 100 may be equal to the number of provided S20 visualization modes. It may also be inferior to the number of provided S20 visualization modes, especially if the number of provided S20 visualization modes is greater than 10.

The method further comprises, for each split view, determining S30 a rendering area of the 3D model associated to the current split view. A rendering area of a 3D model is the result of the projection of the 3D model on a 2D surface. As an example, first the rendering area of the 3D model may be computed for the main view 200 . Second the determining S30 may consist of dividing the computed rendering area of the 3D model based on the size and form of each split view. Indeed, there is a correspondence between the main view 200 and the split view. Said otherwise, it is possible to find the corresponding 2D coordinate in the main view 200 for each 2D coordinate of each split view. The rendering area for each split view 100 can also be computed directly by 3D projecting the 3D model to the split view 100 without computing first the rendering area of the 3D model in the main view 200.

It is worth noting that the rendering area depends also of the position, orientation, size and geometry of the 3D model. The rendering area of the 3D model for one or more split views 100 may be zero. In other word, the 3D model may not have any rendering area in one or more split views 100.

The method renders S40 the 3D model in each split view 100 according to its corresponding visualization mode and determined rendering area. In other words, for the corresponding rendering area of each split view, the rendering is computed based on the corresponding visualization mode and for the rendering area determined in step S30. It is worth noting that steps S30 and S40 may be applied in a same way to an entire 3D scene and therefore our method may be used for rendering at least two visualization modes of a 3D scene.

FIG. 6 shows a first example of the method with four split views 100. When the model is moved or modified by the user in the 3D scene, the rendering areas and the render of each split view 100 are updated. If one or more split views 100 are moved and/or modified, the rendering areas and the render of each split view 100 are updated. It is worth noting that if the main view 200 is still partially visible after the splitting S20, the rendering areas and the render of the main view 200 needs also to be updated if the 3D model and/or one or more of the split views 100 is moved and/or modified.

The method is computer-implemented. This means that steps (or substantially all the steps) of the method are executed by at least one computer, or any system alike. Thus, steps of the method are performed by the computer, possibly fully automatically or semiautomatically. In examples, the triggering of at least some of the steps of the method may be performed through user-computer interaction. The level of user-computer interaction required may depend on the level of automatism foreseen and put in balance with the need to implement the wishes of the user. In examples, this level may be user-defined and/or pre-defined.

A typical example of computer-implementation of a method is to perform the method with a system adapted for this purpose. The system may comprise a processor coupled to a memory and a graphical user interface (GUI), the memory having recorded thereon a computer program comprising instructions for performing the method. The memory may also store a database. The memory is any hardware adapted for such storage, possibly comprising several physical distinct parts (e.g. one for the program, and possibly one for the database).

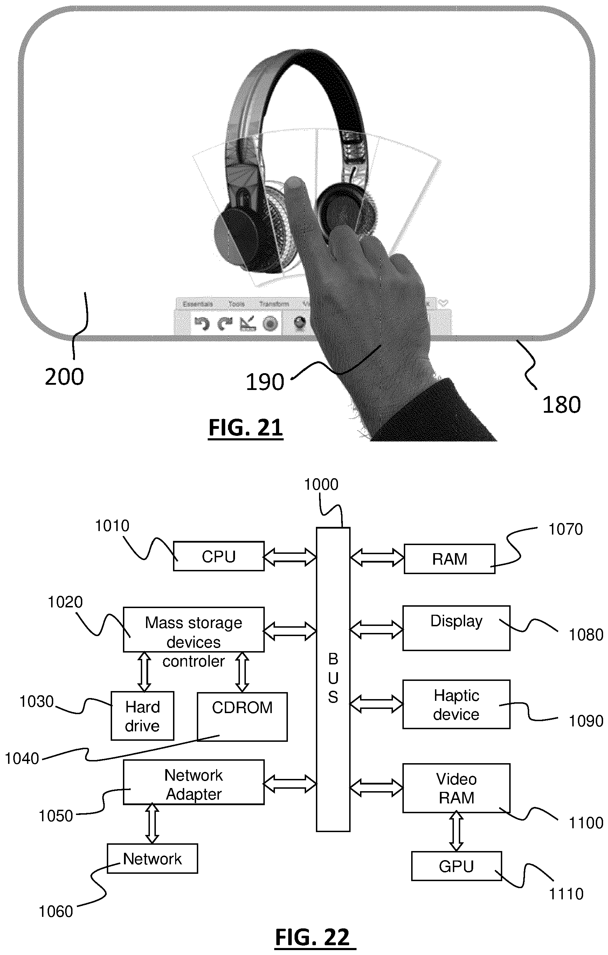

FIG. 22 shows an example of the system, wherein the system may be a client computer system, e.g. a workstation of a user.

The client computer of the example comprises a central processing unit (CPU) 1010 connected to an internal communication BUS 1000, a random access memory (RAM) 1070 also connected to the BUS. The client computer is further provided with a graphical processing unit (GPU) 1110 which is associated with a video random access memory 1100 connected to the BUS. Video RAM 1100 is also known in the art as frame buffer. A mass storage device controller 1020 manages accesses to a mass memory device, such as hard drive 1030. Mass memory devices suitable for tangibly embodying computer program instructions and data include all forms of nonvolatile memory, including by way of example semiconductor memory devices, such as EPROM, EEPROM, and flash memory devices; magnetic disks such as internal hard disks and removable disks; magneto-optical disks; and CD-ROM disks 1040. Any of the foregoing may be supplemented by, or incorporated in, specially designed ASICs (application-specific integrated circuits). A network adapter 1050 manages accesses to a network 1060. The computer may also include a haptic device 1090 such as pointer control device (also referred to as cursor control device) or the like. A pointer control device is used in the computer to permit the user to selectively position a pointer (also referred to as cursor) at any desired location on the display 1080. The display 1080 may be a monitor or the like as known in the art. The display 1080 may be touch-sensitive display 1080. The touch-sensitive display (also referred to as touch screen) is a hardware display unit attached to a computer which responds to touch made on its front surface. It can support one, two or multiple simultaneous touches. In addition, the pointer control device allows the user to select various commands, and input control signals. The pointer control device includes a number of signal generation devices for input control signals to system. In the context of a touch-sensitive display, the haptic device 1090 (a touchscreen sensor and its accompanying controller-based firmware) are integrated on the display and the pointer control device on a touch-sensitive display is an appendage that may be, but is not limited to, a finger, a stylus. In the context of a display that is not a touch-sensitive display, the haptic device 1090 can be, but is not limited to, a mouse, a trackball.

Another typical example of computer-implementation of a method is to perform the method with a system adapted for this purpose, e.g. a server. The system may comprise a processor coupled to a memory; the memory having recorded thereon a computer program comprising instructions for performing the method. The memory may also store a database. The memory is any hardware adapted for such storage, possibly comprising several physical distinct parts (e.g. one for the program, and possibly one for the database). The example of a system showed in FIG. 22 may also be a server, e.g., a server hosting a database.

The server of the example comprises a central processing unit (CPU) 1010 connected to an internal communication BUS 1000, a random-access memory (RAM) 1070 also connected to the BUS. The server may be further provided with a graphical processing unit (GPU) 1110 which is associated with a video random access memory 1100 connected to the BUS. Video RAM 1100 is also known in the art as frame buffer. A mass storage device controller 1020 manages accesses to a mass memory device, such as hard drive 1030. Mass memory devices suitable for tangibly embodying computer program instructions and data include all forms of nonvolatile memory, including by way of example semiconductor memory devices, such as EPROM, EEPROM, and flash memory devices; magnetic disks such as internal hard disks and removable disks; magneto-optical disks; and CD-ROM disks 1040. Any of the foregoing may be supplemented by, or incorporated in, specially designed ASICs (application-specific integrated circuits). One or more mass memory devices may be used for implementing the storage layer of a database. A network adapter 1050 manages accesses to a network 1060. The server may also include a haptic device 1090 such as cursor control device, a keyboard or the like. A cursor control device is used in the server to permit the user to selectively position a cursor at any desired location on display 1080. In addition, the cursor control device allows the user to select various commands, and input control signals. The cursor control device includes a number of signal generation devices for input control signals to system. Typically, a cursor control device may be a mouse, the button of the mouse being used to generate the signals. Alternatively or additionally, the server system may comprise a sensitive pad, and/or a sensitive screen.

The computer program may comprise instructions executable by a computer, the instructions comprising means for causing the above system to perform the method. The program may be recordable on any data storage medium, including the memory of the system. The program may for example be implemented in digital electronic circuitry, or in computer hardware, firmware, software, or in combinations of them. The program may be implemented as an apparatus, for example a product tangibly embodied in a machine-readable storage device for execution by a programmable processor. Method steps may be performed by a programmable processor executing a program of instructions to perform functions of the method by operating on input data and generating output. The processor may thus be programmable and coupled to receive data and instructions from, and to transmit data and instructions to, a data storage system, at least one input device, and at least one output device. The application program may be implemented in a high-level procedural or object-oriented programming language, or in assembly or machine language if desired. In any case, the language may be a compiled or interpreted language. The program may be a full installation program or an update program. Application of the program on the system results in any case in instructions for performing the method.

Preferably, the method may further comprise receiving S50 a selection of one of the plurality of visualization modes, removing S60 the at least two split views 100 and rendering S70 the 3D model according to the selected visualization mode in the main view 200. The user may select one of the plurality of visualization modes with any pointer control device such a mouse device or a finger. The selection may also be semi-automatic. By "semi-automatic", it is meant that a preselection of one or more visualization modes may be done automatically. For example, based on the current available CPU and/or GPU resources of the system, a default visualization mode may be preselected in order to ensure a real-time rendering. Then the user can just confirm or not this preselection. In another example, an automatic selection may be based on the current function used by the user. As an example, if the user is designing a 3D model which represents a car, a visualization mode such as "Shading with edges" visualization may be selected or preselected.

When the selection is received by the system, the split views 100 are removed S60 from the screen. The removing S60 may consist of the deletion or the hiding of the split views 100, thus making the main view 200 entirely visible again. If the main view 200 was replaced during the splitting S20, the main view 200 may replace the split view 100 during the removing S60. The removing S60 may consist of any animations such as a "disappear" of the split views 100 and an "appear" of the main view 200, a "fly out" of the split views 100 and a "fly out" of the main view 200, etc., or any combinations between such animations.

The method allows the user to apply a rendering S70 to the entire 3D model after comparing various renders of the 3D model at once. The method is therefore ergonomically efficient while optimized in term of computer resources. Indeed, the method minimizes user interactions such as mouse clicks and mouse distance travel. Furthermore, as said before, a visualization mode is a set functional data, therefore the user cannot use directly these data to select one visualization mode among the visualization modes available. A render of the 3D model is therefore mandatory for the user to efficiently choose the most adapted visualization mode to their need. Said otherwise, the method guides the user towards an adapted selection of a visualization mode by allowing him to compare various renders simultaneously.

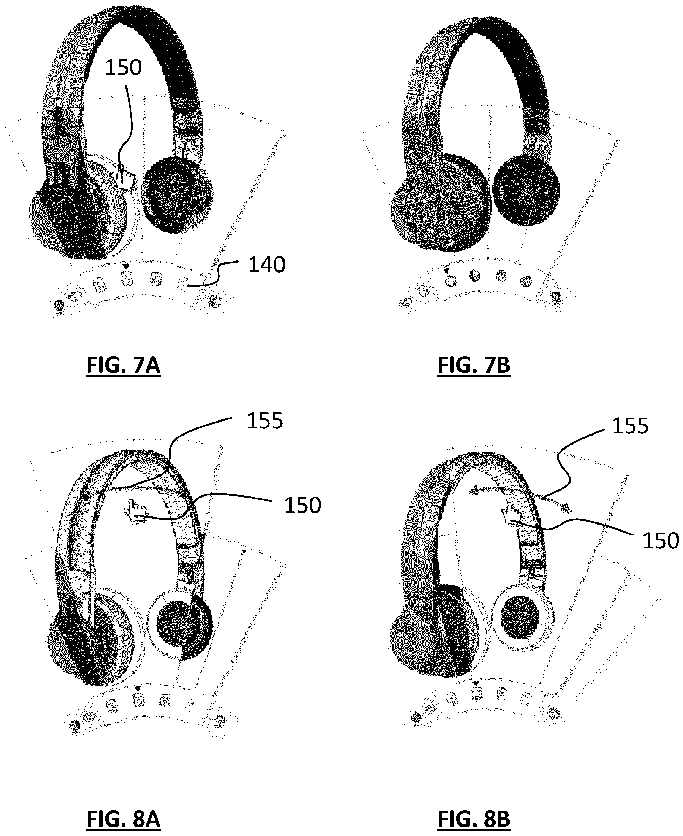

In examples, the receiving S50 may comprise a user interaction with one split view 100 corresponding to the selected visualization mode. For example, the receiving S50 may comprise any user interaction. For example, a mouse click on the split view 100 may be received when the display 1080 is a monitor. If the display device 1080 is a touch sensitive display, the selection may be performed by performing a tap with the finger of the user as shown in FIG. 6 and FIG. 7A. This user-interaction is intuitive and simple. From the beginning of the method to the rendering S70, only one user interaction is mandatory to see various renders based on different visualization modes and to select the visualization mode of interest to render. Furthermore, the receiving S50 comprising a user interaction with one split view 100 does not need any additional 2D interface to be incorporated to the invention therefore it maximizes the area of the various views displayed.

Any animations allowing the transition from the rendering S40 of the split views 100 to the rendering S70 of the selected split view 100 may be used. Preferably, the transition may be an animation consisting of an expansion of the selected split view 100 until its limits of the screen are reached.

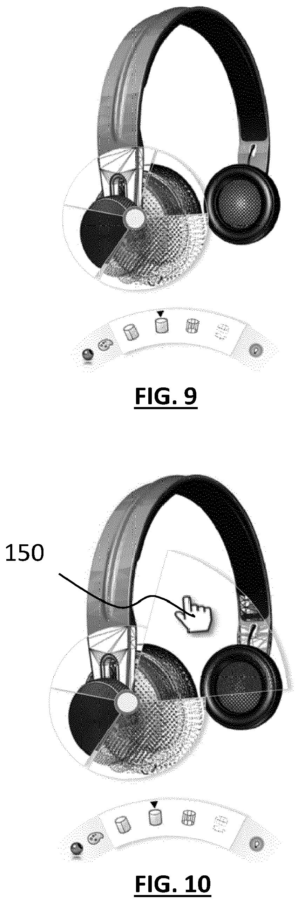

In examples, each split view 100 may comprise a 2D interface, the 2D interface comprising one icon and/or a text. As shown in FIG. 7A, FIG 7B, FIG. 8A, FIG 8B and FIG. 15 to FIG. 18, a 2D interface 140 may be added anywhere in its corresponding split view. As shown in FIG. 9 and FIG. 10, a 2D interface 140 may be added outside its corresponding split view. Having a 2D interface corresponding to each split view 100 helps the user to identify which visualization mode is rendered in which split view. It is useful in many occasions. As an example, if the user wants to share to a colleague his preferred visualization mode for a specific 3D model, he can use the text of the 2D interface to name it. The size of each 2D interface may vary. In a preferred example, the size of each 2D interface is minimized in order to maximize the area of the render of the split views 100 and/or the main view 200. Furthermore, the 2D interface may be partially transparent, therefore the render of the split view 100 or the render of the main view 200 may still be visible in the screen area of the 2D interface.

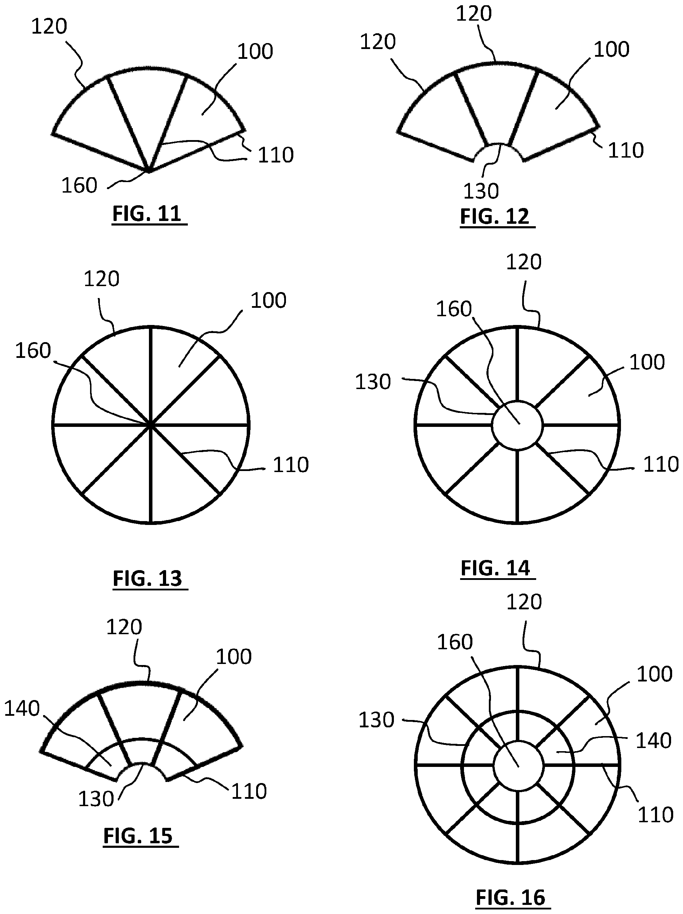

Preferably, the split views 100 may be circle sectors having a shared circle center 160 with a same central angle and radius length. The split views 100 may therefore be circle sectors having the same surface. By "shared circle center 160", it is meant that the split views 100 may share the circle center 160. In other words, the split views 100 have the same (common) circle center 160. A first definition of "circle sector" 100 may be a portion of a disk enclosed by two radii 110 and an outer arc 120. FIG. 11, FIG. 13, FIG. 17, FIG. 18 and FIG. 20 show circle sectors based on the first definition. In the invention, a circle sector may also be a portion of a circle enclosed by two radii 110 and the outer arc 120 and the inner arc 130. The circle sectors as defined in the second definition are used in examples shown in FIG. 6 to FIG. 10, FIG. 12, FIG. 14, FIG. 15, FIG. 16, FIG. 19 and FIG. 21. All circle sectors may share the shared circle center (or disk center) 160 and may have the same central angle and radius length. By "central angle", it is meant the angle between the two radii 110 of the circle sector . By "radius length", it is meant the shortest distance either between the shared circle center 160 and the outer arc 120 or between the outer arc 120 and the inner arc 130.

The shape formed by all circles sectors may be itself a circle sector. For the sake of simplicity, we will name this formed circle sector a Chinese fan from now on. The Chinese fan may have a central angle between 1° to 359°. As a preferred example, the central angle of the Chinese fan may be inferior or equal than 180° and more preferably between 45° to 160°. As an example, if there are 6 split views 100 forming a Chinese fan having an angle of 180°, each split view 100 may have a central angle of 30°. When a Chinese fan is implemented, the radius length may vary and be equal than the height and/or the width of the main view. In a preferred example, the radius length of each split view 100 may be smaller than the height and width of the main view 200 and more preferably equal to 60% of the height of the main view 200. The circle center may be anywhere in the screen area but also be outside the screen area when the central angle of the Chinese fan is smaller than 180°. FIG. 6 to FIG 8, FIG. 11, FIG. 12, FIG. 15, FIG. 17, FIG. 19, FIG. 20 and FIG. 21 show examples of implementation of a Chinese fan.

The shape formed by all circles sectors may also be a circle or a disk. For the sake of simplicity, we will name this formed circle a full circle from now on. This full circle shares the shared circle center (or disk center) 160 than each of the circle sectors. The circle center may be anywhere in the screen area. The full circle may have the same radius length than each of the circle sector. Its radius length may vary and even be equal than half of the height and/or half of the width of the screen area. In a preferred example, the radius length of each split view 100 may be smaller than half of the height and half of the width of the main view 200 and more preferably equal to 30% of the height of the main view 200.

Implementing the invention as a Chinese fan is especially adapted when the number of visualization modes to render is limited. Conversely, implementing the invention as a full circle allows a rendering of a great number of visualization modes.

Switching between an implementation as a Chinese fan and a full circle may be possible. For example, the switching may happened after a user interaction and/or automatically.

In examples, the split views 100 may be circle sectors having a shared circle center 160 with a same central angle and radius length and wherein the 2D interface may be displayed between the shared center 160 of the split views 100 and the split views 100. FIG. 7A, FIG 7B, FIG. 8A, FIG 8B, FIG. 15 to FIG. 18 show examples wherein the 2D interface is displayed between the shared center 160 of the split views 100 and its corresponding split view. Having the 2D interface near the circle center of each split view 100 is preferential. First, because it means all the 2D interfaces are next to each other. Hence, it reduces muscle strain for the interactions with the 2D interfaces. Second, all textual information are grouped and therefore easy to read. Furthermore, each 2D interface may be displayed next to its corresponding split views 100. It is therefore easy for the user to associate the split view 100 with the 2D interface. Third, on a touch-sensitive display 1080, it improves the ergonomics of the invention when the circle center 160 of each split view 100 is near the side of the screen where the wrist of the user is. For example, when the user uses their finger to perform step S50 by interacting with the 2D interface, their hand will not hide the render of the split view. FIG. 21 shows an example wherein the circle center of each split view 100 is near the side of the screen 180 where the wrist of the user is. However, in FIG. 21 the Chinese fan does not contain any 2D interface, therefore the split views 100 are partially hidden by the hand of the user 190.

Preferably, the method further comprises a step (S80) of selecting one of the split views (100) and enlarging it by increasing its central angle and/or increasing its radius length. After receiving an input by the system on one of the split views 100, the split view 100 may be enlarged. The input may be any user interaction such as a click, a long press with a mouse device, a touch or a long touch on touch-sensitive display 1080. FIG. 6, FIG. 7A, FIG. 8A, FIG 8B, FIG. 10 show an icon of a hand representing such interaction 150. For example, the selected split view 100 S50 may be enlarged. In another example, the user may enlarge one or more split views 100 in order to see in a larger view the one or more renders of their interest. When one split view 100 is enlarged, the other split views 100 may be moved away and/or have their central angle reduced. FIG. 8A and FIG. 8B shows an example of split views 100 moved away and FIG. 10 shows an example of split views 100 having their central angle reduced. Only the split views 100 on the right or left side of the enlarged split view 100 may be moved away and/or have their central angle reduced. More than one split view 100 may be enlarged simultaneously and the other split views 100 may be moved away and/or having their central angle reduced. When one or more split views 100 are enlarged only by increasing its radius length, the other split may not be moved away and/or reduced.

The enlarging may also be launched automatically by the system. In other words, the selection may be automatic. For example, after the step S40, each split view 100 may be enlarged starting from the leftmost view to the rightmost view (or conversely).

Enlarging one or more split views 100 by increasing its central angle and/or increasing its radius length provides the ability to the user to inspect in detail the 3D model or the 3D scene. Indeed, it allows the user to see a larger view of the one or more corresponding renders. It is especially useful when a lot of visualization modes are available and therefore a lot of split views 100 are displayed.

In examples, the method further comprising a step S90 of rotating one of the split views 100 about the shared circle center 160 and/or enlarging one of the split views 100 upon receiving an input from a user, the input comprising an interaction with one of the split views 100. The input may be any user interaction such as a click, a long press with a mouse device, a touch or a long touch on touch-sensitive display 1080. FIG. 6, FIG. 7A, FIG. 8A, FIG 8B and FIG. 10 show an icon of a hand representing such interaction 150. Here the range of the rotating about the shared circle center 160 may be computed based on the move of the input received. As an example, to compute the angle of rotation to rotate the split view 100 about the shared center 160, it is possible to compute the angular displacement of the input relatively to the center of the same circle and therefore to obtain the angle of rotation to apply to the split view. FIG. 8A and FIG 8B show examples of a displacement 155 which can be received to compute the angle of rotation to apply to the split view. When one split view 100 is enlarged, the other split views 100 may be rotated about the shared circle center 160 as shown in FIG. 8A and FIG. 8B. In other words, the other split views 100 may be rotated around their circle center away from the moved split view. Only the split views 100 on the right or left side of enlarged split view 100 may be moved away. When one split view 100 is rotated about the shared circle center 160, the central angle of the other split views 100 may also be reduced.

The rotating about the shared center 160 may also be automatically launch by the system at various angular speed after step S40 or after receiving an input from the user.

Rotating one of the split views 100 about the shared center 160 allows the user to inspect in detail a specific part of the 3D model (or the 3D scene) with a visualization mode of interest. Indeed, if the split view 100 corresponding to the visualization mode of interest does not render a specific part of the 3D model (or the 3D scene), the user can just move the split view. Combining the moving with an enlargement is also possible and provides to the user a larger render in the split view 100 of interest.

One of the split view 100 may be enlarged after receiving an input from a user, the input comprising an interaction with the one of the split views 100. Any interaction may be used. As an example, a click with a mouse device or a long press with the finger could be used as the interaction to enlarge one of the split view.

In examples, the shared center 160 may be located inside the main view 200 and further comprising a step S100 of moving the shared center 160 by an input from a user. FIG. 9, FIG. 10, FIG. 13, FIG. 14, FIG. 16 and FIG. 18 show examples of the invention with a shared center 160 located inside the main view 200. FIG. 6 to FIG. 8, FIG. 11, FIG. 12, FIG. 15, FIG. 17, FIG. 19 and FIG. 20 show examples of the invention which may have the shared center 160 located inside or outside the main view 200. The shared center 160 may be materialized by a 2D interface, the 2D interface being displayed at the center. The input of the user may comprise an interaction with the 2D interface displayed at the center. As an example, FIG. 9 and FIG. 10 show an example of a 2D interface, which may be used to receive the input from the user in order to move the shared center 160 and therefore the full circle. Any other 2D interface allowing to receive an input to move the shared center 160 could be used.

Moving the center shared by the split views 100 provides to the user another way to inspect the 3D model or the 3D scene. It allows the user to inspect in detail a specific part of the 3D model (or the 3D scene) with a visualization mode of interest. Moving the center may be used in combination or not with the enlarging of one or more split views 100 and/or the rotating one of the split views 100 about the shared center 160.

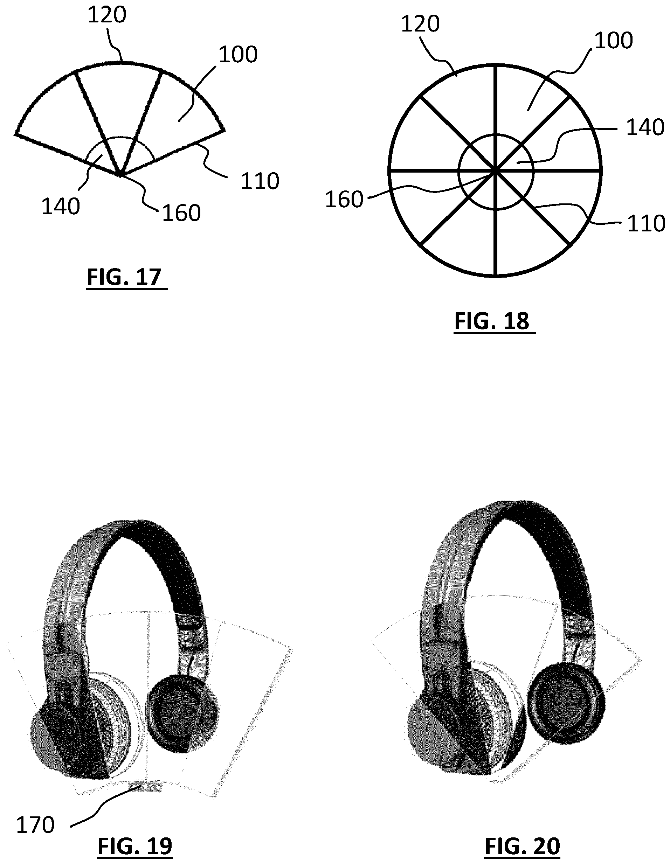

In examples, the shared center 160 may be located outside the main viewer. FIG. 6 to FIG. 8, FIG. 11, FIG. 12, FIG. 15, FIG. 17, FIG. 19 and FIG. 20 show examples of the invention with the shared center which may be located outside the main viewer. It is worth noting that having the shared center located outside the main viewer is only possible when the invention is implemented as a Chinese fan. When the shared center is located outside the main viewer, the Chinese fan may also be movable. For example, the user may move the Chinese fan by interacting directly with any of the split view 100 of the Chinese fan. In another example, a 2D interface 170 may be added between the split views 100 and the shared center as shown in FIG. 19. The 2D interface 170 may also be added to the split views 100 when a 2D interface 140 is added to each split view. In a first example, the shared center may be located outside the main viewer and then be moved inside the main viewer. In a second example, the shared center may be located inside the main viewer and then outside the main viewer after the move of the Chinese fan or the move of the full circle. For the first example, the implementation may switch from the Chinese fan to the full circle. For the second example, the implementation may switch from the full circle to the Chinese fan.

Having split views 100 as circle sectors is ergonomically interesting. For example, on a touch-sensitive display 1080, the user can position their wrist near the shared circle center 160 and then be able to interact with all split views 100 without having to move its wrist. FIG. 21 shows an example wherein the wrist of the hand of the user 190 is positioned near the shared circle center 160. In another example with a haptic device 1090 such as a mouse device used in combination with a display 1080 such as a monitor, the user can interact with a lot of split views 100 without moving their wrist. Indeed, when rotating their wrist, the motion of the mouse device will form a circle sector which may pass over the split views 100. Obviously, this circle sector will pass over the split views 100 only if the wrist is positioned correctly.

In examples, each split view 100 may be separated to its neighbor by a radius line 110 or by an angular space. Each split view 100 has either one or two neighbors. The separation may be a radius line 110 of various thickness. The term "radius line" may be defined as a line forming a radius of the full circle or the Chinese fan. More precisely, by the term "radius line" it is meant a segment between the shared circle center 160 and the outer arc 120. The separation may also be an angular space. This angular space may for example be a circle sector. Its shape may be the same than the split views 100 but with a smaller central angle.

The separation may be materialized in various ways. For example, it may be a monochromic line (or monochromic angular space). In another example, it may display the main view 200.

Using a radius line with a small thickness as a separation such as shown in FIG. 6 to FIG. 10 maximizes the surface used by the invention. By small thickness, it is meant a thickness of less than 8 pixels, or preferably of less than 6 pixels. Using an angular space as a separation may be particularly of interest to compare the render of each split view 100 with the render of the main view 200. Indeed, if the main view 200 is displayed in the angular spaces, the main view 200 will be displayed next to each split view. Furthermore, by rotating the split view about the shred center 160, the user will easily compare the render of the main view 200 with the render of a split view 100 on the same specific part of the 3D model.

## Claims

1. A computer-implemented method for rendering at least two visualization modes of a 3D model:
- rendering (S10) the 3D model in a main view (200) according to a first visualization mode;
- splitting (S20) the main view (200) in at least two split views (100), each split view (100) corresponding to one visualization mode of a plurality of visualization modes;
- for each split view, determining (S30) a rendering area of the 3D model associated to the current split view; and
- rendering (S40) the 3D model in each split view (100) according to its corresponding visualization mode and determined rendering area.

2. The computer-implemented method of claim 1 further comprising:
- receiving (S50) a selection of one of the plurality of visualization modes;
- removing (S60) the at least two split views (100); and
- rendering (S70) the 3D model according to the selected visualization mode in the main view (200).

3. The computer-implemented method of claim 2 wherein the receiving (S50) comprises a user interaction with one split view (100) corresponding to the selected visualization mode.

4. The computer-implemented method of any of the preceding claims wherein each split view (100) comprises a 2D interface (140), the 2D interface comprising one icon and/or a text.

5. The computer-implemented method of any of the preceding claims wherein the split views (100) are circle sectors having a shared circle center (160) with a same central angle and radius length.

6. The computer-implemented method of claim 4 wherein the split views (100) are circle sectors having a shared circle center (160) with a same central angle and radius length and wherein the 2D interface is displayed between the shared center (160) of the split views (100) and the split views (100).

7. The computer-implemented method of claim 5 or claim 6 further comprising a step (S80) of selecting one of the split views (100) and enlarging it by increasing its central angle and/or increasing its radius length.

8. The computer-implemented method of claim 6 or claim 7 further comprising a step (S90) of rotating one of the split views (100) about the shared circle center (160) and/or enlarging one of the split views (100) upon receiving an input from a user, the input comprising an interaction with one of the split views (100).

9. The computer-implemented method of any of claims 6 to 8 wherein the shared center (160) of the split views (100) is located inside the main view (200) and further comprising a step (S100) of moving the shared center (160) by an input from a user.

10. The computer-implemented method of any of claims 6 to 8 wherein the shared center (160) of the split views (100) is located outside the main viewer.

11. The computer-implemented method of any of the preceding claims wherein each split view (100) is separated to its neighbor by a radius line (110) or by an angular space.

12. A computer program comprising instructions to perform the method of any one of claims 1 to 11.

13. A computer readable storage medium having recorded thereon a computer program of claim 12.

14. A computer adapted to perform the method of any one of claims 1 to 11.
